# EUROPEAN PATENT APPLICATION

(11) **EP 1 743 960 A1**
(43) Date of publication of application: **17.01.2007**
(21) Application number: 05728571.0
(22) Date of filing: 11.04.2005
(51) Int. Cl.: C30B 15/08, C30B 29/28, C30B 29/30

(54) **SELF-COATED SINGLE CRYSTAL, AND PRODUCTION APPARATUS AND PROCESS THEREFOR**

(30) Priority: 09.04.2004 JP 2004116263; 12.04.2004 JP 2004116381
(71) Applicant: Tohoku Techno Arch Co., Ltd., Sendai-shi, Miyagi 980-8577 (JP)
(72) Inventor: FUKUDA, Tsuguo, Sendai-shi, Miyagi 9818007 (JP); YOSHIKAWA, Akira, Sendai-shi, Miyagi 9820826 (JP); KAGAMITANI, Yuji, Miyagi 9800874 (JP)
(74) Representative: Dr. Weitzel & Partner
(86) International application number: PCT/JP2005/007033
(87) International publication number: WO 2005/098096

(57) **Abstract**

It is an object of the present invention to provide a self-coated single crystal that without any special step conducted after crystal growth, has its circumference coated with a layer of different properties. A self-coated single crystal according to the present invention is **characterized in that** in operations comprising melting crystal materials for a core and a clad in a single crucible and carrying out growth of a single crystal through a pulling up method or a pulling down method, a grown single crystal in an as-growth condition has its circumference self-coated with a clad whose refractive index is lower than that of the core.

## Description

### Technical Field

The present invention relates to a so-called self-coated single crystal having a coating layer (a layer having characteristics different from those of the inside) already formed on its circumference in an as-growth condition of the single crystal, and a production apparatus and method thereof.

### Background Art

Patent Reference 1: Japanese Patent Application Laid-open No. 265293-1998
Patent Reference 2: Japanese Patent Application Laid-open No. 259375-1996
Patent Reference 3: Japanese Patent Application Laid-open No. 278994-1999
Patent Reference 4: Japanese Patent Application Laid-open No. 251098-1998

A crystal containing an optically-active ion is used for many light-emitting mediums such as a solid laser or a scintillator device. Since the solid laser has a higher density degree of a laser operation material than that of a gas laser, an output which is as high as 100 MW can be obtained with a pulse wave in several-ten n seconds. Further, an efficiency can be promoted by using a semiconductor laser as an excitation light source. Since a laser using Yb has a better quantum efficiency than that of a laser using Nd and the same light emission level as an excitation level, it generates a small amount of heat in a laser oscillation process, and hence it is important as a high-output laser.

However, in any light-emitting medium, light is radiated in all directions in a light emission process, only a small mount of light radiated in a direction of a detector can be taken out, and hence an essential loss is large. Further, since heat generation involved by excitation provokes a thermal birefringence effect, a thermal lens effect, a reduction in an intensity of output light due to a thermal population or deterioration in a quality of a beam, continuous oscillation of a high output is difficult. Therefore, special coating is provided as a post-processing step in a prior art.

That is, in a crystal which is not subjected to crystal surface coating, light is radiated in all directions in a light emission process, only a small amount of light radiated in a direction of a detector can be taken out, and an essential loss is large. Therefore, in a scintillator device with a weak light emission amount using a crystal or the like, a surface of a crystal is coated in order to condense radiated light, thereby increasing a light emission intensity.

On the other hand, as currently utilized methods as a method of growing a single crystal of various kinds of materials, there are many methods such as a Cz method, a Bridgman method, an EFG method, a hydrothermal synthesis method, epitaxial growth or a thin film method. This method requires a considerable cost and days in order to obtain a single crystal, and hence a speed of developing a novel material is obstructed. Furthermore, since a cutting margin required due to cutting a crystal after manufacture is generated, a yield ratio is poor, and an entire surface must be processed, thus increasing a price of the crystal.

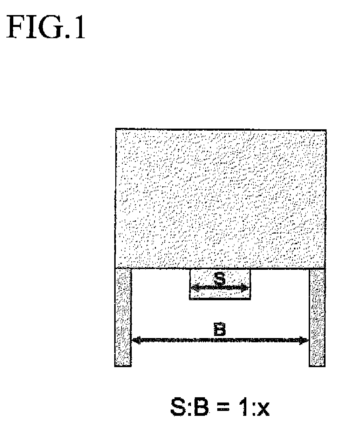

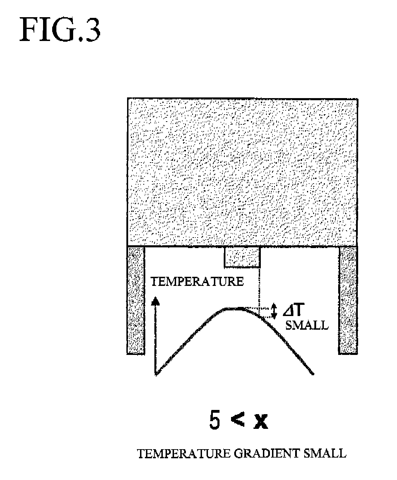

In contrast to the single crystal growth method, a micro pulling down method is known (Patent Reference 1, Patent Reference 2 and Patent Reference 3). For example, Patent Reference 1 discloses a specific apparatus at its paragraph number (0025) or in FIG. 1. Moreover, FIG. 3 in Patent Reference 3 also illustrates a specific apparatus.

In technologies disclosed in Patent Reference 1 and Patent reference 2, a crystal can be grown at a speed which is one or two order higher than that in other melt growth methods. Therefore, a time required to manufacture a crystal is short, and a single crystal with a significant size and a high quality can be obtained from a small amount of raw materials. Additionally, since a crystal is pulled out from a narrow hole in a bottom portion of a crucible, the crystal can be grown without removing an impurity floating on an upper surface of a melt.

However, even in the technologies disclosed in Patent Reference 1 or Patent Reference 2, when using a manufactured crystal as an optical element, the crystal must be cut to a target size and an entire surface of the crystal must be polished and coated after manufacture of the crystal.

Further, in regard to thermal conductivity, since a coefficient of thermal conductivity of a crystal is inherent to each crystal, heat generation involved by excitation cannot be reduced in a light-emitting medium having a low coefficient of thermal conductivity, a thermal birefringence effect, a thermal lens effect, a reduction in an intensity of output light due to a thermal population or deterioration in a quality of a beam is provoked, and hence continuous oscillation of a high output with a high quality is difficult.

The present inventor has applied this micro pulling down method to a fluoride and examined an apparatus and a manufacturing method (Patent Reference 1), thereby succeeding in growth of a crystal having a diameter of approximately 1 mm. However, when evaluating whether a material of a crystal grown by this method is suitable for various kinds of applications such as a solid laser or a scintillator, it has been revealed that a crystal having a shape meeting each application is required.

According to Patent Reference 4, an oxide single-crystal material constituting a core portion is molten in a first crucible to obtain a first melt, an oxide single-crystal material constituting a clad portion is molten in a second crucible to obtain a second crucible melt, the first and second melts are brought into contact with a seed crystal, and then the second melt is pulled down in contact with the first melt while pulling down the first melt. As a result, the core portion and the clad portion are integrally pulled down.

However, in this technology, a heating method is difficult, and condition setting is very hard. Furthermore, a seed is individually set in both the core portion and the clad portion. However, setting a seed in both the core portion and the clad portion is actually very difficult.
A thickness of the clad portion becomes uneven unless a positional relationship between the first crucible and the second crucible is accurately controlled.

### Disclosure of the Invention

### Problem to be Solved by the Invention

It is an object of the present invention to provide a self-coated single crystal having an circumference coated with a layer of different properties without any special step conducted after crystal growth. Means for Solving the Problem

A self-coated single crystal according to the present invention is characterized in that in operations comprising melting crystal materials for a core and a clad in a single crucible and carrying out growth of a single crystal through a pulling up method or a pulling down method, the grown single crystal in an as-growth condition has its circumference self-coated with the clad whose refractive index is lower than that of the core.

The present invention is characterized in that the single crystal is a single crystal grown by a micro pulling down method.
The present invention is characterized in that the single crystal is a light-emitting medium single crystal.
The present invention is characterized in that the single crystal is a single crystal for a solid laser or a scintillator.

The self-coating is characterized in that a temperature distribution in the vicinity of an interface between a melt and the crystal is a temperature distribution causing self-coating as a result of the fact that a melting degree of a specific constituent component in the melt is selectively lowered due to a temperature difference to thereby obtain a composition of the clad, thus realizing self-coating.
The present invention is characterized in that the material serving as the clad material is a material obtained by adding a rare-earth element or a transition element in a material serving as the core material.

An additive-free material is preferably used as the clad material and, on the other hand, a material in which an activator agent such as a rare-earth element or a transition element is added is preferably used as the core material. Since a melting point of a material having an element added therein is generally lowered by several °C to several-ten °C, an additive-free crystal grows on the circumference (the clad portion) when a temperature on the outer side (the clad portion) is low.

Since an additive-free crystal has a higher coefficient of thermal conductivity and a smaller refractive index, heat can be efficiently radiated, and light which is to travel from the inside toward the outside can be suppressed from proceeding toward the outside by a total reflection phenomenon, thereby obtaining a merit that light can be taken out from a longitudinal direction alone of the crystal.

The present invention is characterized in that the core material of the single crystal consists of a material which is one of Yb:YAG(Y₃Al₅O₁₂), Nd:YAG(Y₃Al₅O₁₂), Yb:LuAg(Lu₃Al₅O₁₂), Nd:LuAG(Lu₃Al₅O₁₂), Ti:Sapphire(α-Al₂O₃), Cr:Sapphire(α-Al₂O₃), Ce:GSO(Gd₂SiO₅), Ce:LSO(Lu₂SiO₅), Ce:LiCAF(LuCaAlLiF₆), Ho:LuLF(LuLiF₄), HoTm:YLF(YLiF₄), Ce:PrF₃, LN(LiNbO₃) and LT(LiTaO₃).
Each additive-free material is preferably used for the clad portion. For example, it consists of additive-free Al₂O₃ (sapphire).

A production method of a self-coated single crystal according to the present invention is characterized by melting materials having different melting points in a single crucible, providing such a temperature gradient as a temperature is lowered from a central portion toward an edge portion on a solid-liquid interface and carrying out growth of the crystal by a pulling down or pulling up method.
The temperature gradient can be controlled by setting B/S to a predetermined value. That is, a production apparatus of a single crystal according to the present invention is characterized in that, in a production apparatus of a single crystal which carries out pulling-down growth of a single crystal from a hole formed in a bottom portion of a crucible, a planar protruding portion (which is called a shaper) having an outer diameter (S) which is not greater than fivefold of an inner diameter (B) of the crucible is provided around the hole on an exit side.

The present invention is characterized in that 1.2 < (B/S) < 5 is achieved.
The present invention is characterized in that 1.5 < B/S < 4.5 is attained.
Considering a part around the protruding portion under the crucible, since the protruding portion is a part of the crucible, this portion itself generates heat, and heat is also conducted from a crucible body, and hence a temperature is high. However, considering a plane with the same height, this plane has a distribution that a temperature is lowered in the vicinity of the circumference of the protruding portion. In this regard, when the circumference of the crucible body is sufficiently large, a temperature distribution around the protruding portion becomes uniform so that presence/absence of the protruding portion can be ignored. It has been revealed that its threshold value is B/S = 5.

A production method of a single crystal according to the present invention is a production method of a self-coated single crystal according to claim 8 characterized in that a planar protruding portion having an outer diameter (S) which is not greater than fivefold of an inner diameter (B) of the crucible is provided around a hole formed in a bottom portion of the crucible on an exit side, thereby carrying out growth of the single crystal.
In the production method of a single crystal which caries out pulling-down growth of a single crystal from a hole formed in a bottom portion of a crucible, it is characterized that a planar protruding portion having an outer diameter (S) which is not greater than threefold of an inner diameter (B) of the crucible is provided around the hole on an exit side, thereby performing growth of the single crystal.
The present invention is characterized in that 1.2 < B/S < 5 is achieved.
The present invention is characterized in that 1.5 < B/S < 4.5 is attained.
As a material which becomes a clad, a material having a higher melting point than that of a material which becomes a core.
An inert gas is flowed from a lower side toward an upper side of a crucible so that an outer side of a melt is cooled, thereby realizing a desired temperature gradient. In general, an ambient gas enters from information of the crucible. Therefore, cooling is further intensively performed by supplying the ambient gas such as a nitrogen gas or an argon gas from the lower side of an after-heater. Then, growth is particularly carried out.

Since an outer side (a circumferential portion when a cross section of S is taken into consideration) of a crystal is intensively cooled, a temperature is relatively reduced, and an additive-free crystal having a high melting point is further preferentially crystallized.
It is to be noted that a larger temperature gradient to be formed is preferable. Increasing the temperature gradient narrows a boundary region between the core and the clad, thus obtaining a single crystal having a further precipitous composition change.

### Effect of the Invention

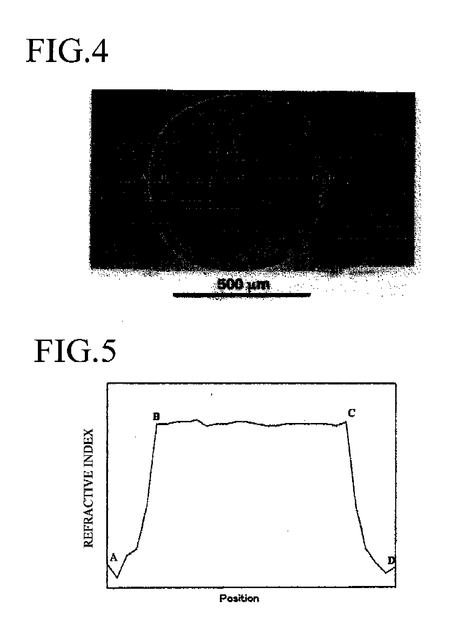

A self-coated rod-like crystal is manufactured by a micro pulling down method (a µ-PD method). The µ-PD method is a method which pulls out a raw material molten in a crucible from a hole at an end below the crucible to manufacture a crystal. A composition in which a positive ion ratio is shifted approximately -10% in a light-emitting medium intended to compose a crystal is determined as a starting material, and a phase with a low refractive index generated due to composition shifting is carried to an end of a melt when a temperature gradient in the melt is sufficiently high, thereby solidifying the crystal so as to be coated (FIGS. 1 and 4).

Here, it is assumed that S is a width of a shaper at an end below the crucible, B is a width of a body, and S:B = 1:x (FIG. 1). A precipitous temperature gradient is provided in the melt and the crystal is coated (FIG. 2) when x < 5, but a sufficient temperature gradient is not provided in the melt and the crystal is not coated (FIG. 3) when x > 5. In manufacture of an extra fine fiber, a size of the shaper must be suppressed, x becomes large, and self-coating is difficult. In this case, when an Ar or N₂ gas is flowed from the lower side toward the upper side of the crucible, the outer side of the melt is cooled by the gas, a precipitous temperature gradient can be realized, and the crystal can be coated even in case of x - 30. According to this technology, processing two surfaces alone of the single crystal can suffice, thus facilitating processing of the crystal.

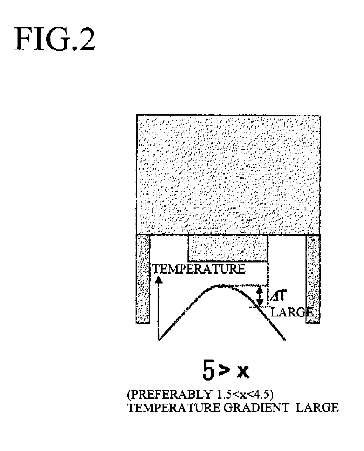

Since the inside of the crystal having a high refraction index becomes the core and the coating portion becomes the clad (FIGS. 2 and 5), light radiated in all directions from the light-emitting medium can be condensed based on total reflection, and a dramatic increase in an light emission amount obtained in a detector was confirmed.

A cooling effect can be demonstrated by coating a surface of the crystal with a material having a high coefficient of thermal conductivity, and heat generated in a light emission step can be released to the outside of the crystal. As a result, high-output excitation, continuous oscillation or light emission at a high temperature becomes possible.

Cutting and processing two surfaces alone of the crystal can suffice, and a yield ratio becomes excellent. Further, complex processing labor can be greatly eliminated, and a low price can be set.

### Brief Description of the Drawings

FIG. 1 is a conceptual view showing a crucible bottom portion having a shaper provided thereto.
FIG. 2 is a conceptual view showing a case where 5 > x in FIG. 1.
FIG. 3 is a conceptual view showing a case where 5 < x in FIG. 1.
FIG. 4 is an appearance diagram of a self-coated LN single crystal in Embodiment 2.
FIG. 5 is a graph sowing an in-crystal refractive index distribution in the single crystal depicted in FIG. 4.

### Best Mode for Carrying out the Invention

The present invention provides a method (a micro pulling down method) which pulls down a single crystal from a crucible which has a hole in a bottom portion and accommodates a melt to carry out growth of a single crystal, and is characterized in that a shape of a crystal to be grown can be controlled by designing a shape of a crucible bottom hole or a crucible bottom portion.

A melt exiting from the hole of the crucible is transmitted through an outer surface of an outer bottom portion of the crucible because of its wettability. A range that the melt wets varies depending on properties of the crucible (e.g., a material or a degree of surface roughness), properties of the hole (e.g., a diameter or a length of the hole) and properties of the melt (e.g., a material or a temperature). The range of wettability is obtained in accordance with the crucible, the melt and the hole. Designing the shaper into an arbitrary planar shape within the range of wettability can grow a crystal corresponding to the arbitrary planar shape.

The shaper can have an arbitrary shape. For example, the shaper can be designed to have an arbitrary dimension which is not smaller than a size of the hole as long as it has a circular shape, an elliptic shape, a square shape, a rectangular shape or any other polygonal shape and its planar shape fall within the range of wettability.

Although the shaper can be formed on the crucible itself, a shaper having a desired shape may be disposed to the crucible.
It is preferable to set a step of a protrusion (a vertical length with respect to a lower surface of a protruding portion) to be not smaller than 1 mm. When the step is set to be not smaller than 1 mm, the melt with the excellent wettability can be prevented from being raised, and a single crystal having an arbitrary shape can be formed by a pulling down method. It is to be noted that 5 mm is preferable as an upper limit. When the step exceeds 5 mm, a melt path becomes long, whereby a problem occurs in some cases. A value of 1.5 mm to 3 mm is preferable.

Although the range of wettability varies depending on properties of the crucible, properties of the hole and properties of the melt, it is good enough to obtain each range in advance by an experiment or the like and design a planar shape of the outer surface of the crucible bottom portion in accordance with the obtained range.

For example, when a platinum crucible is used, wettability of each of platinum and a fluoride is relatively good. Therefore, a phenomenon that the melt rises through the crucible can be observed when a shape of the crucible is not taken into consideration. On the contrary, the present invention is characterized in that a shape of a crystal can be controlled by utilizing this phenomenon and exercising ingenuity in making a shape of the bottom surface of the crucible. That is, a crystal having a diameter of 2 mm or above (a diameter of 2 to 5 mm) which is difficult to be produced in a carbon crucible can be grown, and a crystal having a diameter of 2 mm or below (a diameter of 0.5 to 2 mm) can be likewise grown.

In this case, a bottom hole of the crucible is 0.2 to 0.5 mm, the bottom surface having this hole, i.e., a portion through which the melt flows due to its wettability is set to have a diameter of approximately 0.5 to 5 mm, and a structure in which the melt does not rise through the crucible is adopted, thereby growing a crystal depending on a shape of this structure.

Furthermore, a plate-like crystal can be grown when a shape of the crucible bottom surface has a width of 0.5 mm and a length of 10 mm, and an angular crystal can be grown when this shape is, e.g., 3 mm x 3 mm.

A material in which a small mount of Al₂O₃ (sapphire) is added in Yb-added YAG is taken as an example. A small amount of sapphire is readily transported to an end of the melt by convection because it has a light weight. Here, since a melting point (2050°C) of sapphire is higher than a melting point (1930°C) of YAG which is the melt, sapphire is cooled at the end of the melt and solidified to coat a garnet phase. Moreover, added Yb enters the garnet phase alone to become a light-emitting medium. A refractive index of Yb:YAG is increased to become a core when Yb is added, and an outer sapphire phase becomes a clad with a low refractive index. Therefore, light emitted from the core repeats total reflection and can be taken out without any loss.

Additionally, sapphire in the clad portion has a high coefficient of thermal conductivity which is second to that of a rare-earth oxide in oxides, heat generated in a light emission process can be efficiently released, laser oscillation with a high output is possible without requiring a cooling device, and the present invention is expected in a reduction in size of a device.

### Embodiment 1

Embodiments according to the present invention will now be described hereinafter in detail.
A self-coated crystal was manufactured by a high-frequency induction heating type micro pulling down method (a µ-PD method). As a crucible material and an after-heater, Ir or Pt was used. As a crucible, one having a flat shaper disposed at a lower end thereof was used. As shown in FIG. 1, it is assumed that S is a diameter of the shaper on the crucible bottom portion and B is a radius of a body portion. When S:B = 1:x and 1.2 < x < 5 or 1.5 < x < 4.5, the crystal was self-coated.
That is because, as shown in FIG. 2, when x < 5, a temperature difference between a central portion and an edge portion of the shaper becomes 100°C or above, and a phase produced by shifting of a composition at the edge portion due to this precipitous temperature gradient is solidified to coat the crystal. Further, as shown in FIG. 3, when x > 5, a temperature difference between the central portion and the edge portion of the shaper becomes less than 100°C, the crystal is hardly coated.
A size of the shaper must be suppressed in manufacture of an extra fine fiber, and x is increased to make self-coating difficult. In this case, when an Ar or N₂ gas is flowed from a lower side toward an upper side of the crucible, an outer side of the melt is cooled by the gas, and a precipitous temperature gradient is realized, thereby enabling coating of the crystal even with x - 30.

### Embodiment 2

A self-coated LN single crystal was manufactured in an Ar gas or 2% oxygen mixed Ar gas atmosphere by using a Pt crucible and a Pt after-heater.
As a seed crystal, an LN single crystal was used. As raw materials, powders of Li₂CO₃(4N), Nb₂O₅(4N), MnO₂(4N) were used.
As a starting material, one which has a positive ion ratio matching with that of LiMnₓNb₁₋ₓO₃ (0 < x 0.5) and was sintered for 24 hours or more at 800°C was used. The crucible was charged with 1.0 g of the raw materials. A crystal was manufactured at a growth speed which is not greater than 3.0 mm/min. The obtained crystal was a fiber having a diameter of approximately 1.0 mm to 3.0 mm, and an LiNbO₃ single crystal was coated with Li(Mn, Nb)O₃ when x < 0.3. FIG. 4 shows its appearance.
In a refractive index distribution at 633 nm of the obtained crystal, a refractive index is high at the central portion as shown in FIG. 5, and a core and a clad are formed.

### Embodiment 3

Self-coated Yb:YAG was manufactured by using Ir for a crucible and an after-heater in an Ar atmosphere in order to avoid oxidation of Ir. As a seed crystal, a YAG<111> single crystal was used. As raw materials, powders of Y₂O₃(4N), Yb₂O₃(4N) and Al₂O₃(5N) were used.
As a starting material, one which was weighed in such a manner that its positive ion ratio matches with that of (YbₓY₁₋ₓ)₃Al₅O₁₂+_{y}Al₂O₃ (0 < x < 1, y < 3) and sintered for 24 hours or more at 1450°C was used, and the crucible was charged with 2.0 g of this material. A crystal was manufactured at a growth speed which is not greater than 3.0 m/min.
The obtained crystal was a fiber having a diameter of approximately 1.0 mm to 3.0 mm, and the Yb:YAG single crystal was coated with Al₂O₃ when 0 < x < 1 and y < 1.

### Industrial Applicability

According to the present invention, the following various effects can be achieved.
1. A shape of a crystal has selectivity and crystal shaping processing after manufacture is not required since the crystal is manufactured by the µ-PD method.
2. A technology by which a surface of a crystal is coated with a material having a low refractive index in a crystal manufacture process was established. Further, according to this technology, cutting a crystal and processing an entire surface of the crystal can be eliminated after manufacture of the crystal.
3. Light radiated in a forward direction in a crystal can be condensed onto a detector by total reflection with a reduced loss by coating a crystal surface with a film having a low refractive index.
4. A cooling effect can be demonstrated and heat generated in a light emission process can be successfully released to the outside of a crystal by coating a crystal surface with a film having a high coefficient of heat conductivity. As a result, excitation with a high output is enabled.
5. The self-coating technology can be used in manufacture of all light mediums such as a solid laser crystal or a scintillator crystal.
6. Since coating is performed in a process of manufacturing a rod-like crystal by the µ-PD method, processing after manufacture is cutting a rod and machining a cut surface alone, thereby increasing a possibility of supply at a low price in the future.
7. In a solid laser using a self-coated single crystal, an amount of light emission is increased, and a loss in a light emission process can be avoided.
8. A cooling effect of a light-emitting medium can be also demonstrated by a coating material, thereby enabling a use as a stable high-output laser medium.
9. In a single crystal having a light-emitting medium surface self-coated with a crystalloid with a small refractive index in a crystal manufacturing process, a loss of light produced in a light emission process can be suppressed by total reflection, and coating with a material having a high coefficient of thermal conductivity can realize a high cooling effect.
10. Each seed does not have to be set in both a core portion and a clad portion. Moreover, since the number of crucible to be used is one, positioning of first and second crucibles is of course unnecessary.

## Claims

1. A self-coated single crystal **characterized in that**, in a process of melting crystal materials for a core and a clad in a single crystal and carrying out crystal growth by using a single-crystal pulling up method or pulling down method, the grown single crystal has its circumference self-coated with the clad having a refractive index lower than that of the core in an as-growth condition.

2. The self-coated single crystal according to claim 1, wherein the single crystal is a single crystal grown by a micro pulling down method.

3. The self-coated single crystal according to claim 1 or 2, wherein the self-coating is realized as a result of the fact that a temperature distribution in the vicinity of an interface between a melt and the crystal is a temperature distribution which causes self-coating since a melting degree of a specific constituent component in the melt is selectively lowered due to a temperature difference and a composition of the clad is thereby provided.

4. The self-coated single crystal according to one of claims 1 to 3, wherein the single crystal is a single crystal for a light-emitting medium.

5. The self-coating single crystal according to one of claims 1 to 4, wherein the single crystal is a single crystal for a solid laser or a scintillator.

6. The self-coated single crystal according to one of claims 1 to 5, wherein a material serving as the clad material is a material obtained by adding a rare-earth element or a transition element in a material serving as a core material.

7. The self-coated single crystal according to one of claims 1 to 6, wherein, in the single crystal, a material which becomes the core consists of a material which is one of Yb:YAG, Nd:YAG, Yb:LuAG, Nd:LuAG, Ti:Sapphire, Cr:Sapphire, Ce:GSO, Ce:LSO, Ce:LiCAF, Ho:LuLF, HoTm:YLT, Ce:PrF₃, LN and LT.

8. A production method of a self-coated single crystal **characterized by** comprising: melting materials having different melting points in a single crucible; providing such a temperature gradient as a temperature is lowered from a central portion toward an edge portion on a solid-liquid interface; and carrying out crystal growth by a pulling down or pulling up method.

9. The production method of a self-coated single crystal according to claim 8, wherein a planar protruding portion having an outer diameter which is not greater than fivefold of an inner diameter (B) of the crucible is provided around a hole formed in a bottom portion of the crucible on an exit side to grow the single crystal.

10. The production method of a self-coated single crystal according to claim 9, wherein 1.2 < (B/) < 5 is achieved.

11. The production method of a self-coated single crystal according to claim 10, wherein 1.5 < (B/S) < 4.5 is achieved.

12. The production method of a self-coated single crystal according to one of claims 8 to 11, wherein an outer side of the melt is cooled by flowing an inert gas from a lower side toward an upper side of the crucible, thereby realizing a desired temperature gradient.

13. The production method of a self-coated single crystal according to one of claims 8 to 12, wherein a material serving as the clad material is a material obtained by adding a rare-earth element or a transition element in a material serving as a core material.

14. The production method of a self-coated single crystal according to one of claims 8 to 13, wherein the core of the single crystal consists of a material which is one of Yb:YAG, Nd:YAG, Yb:LuRG, Nd:LuAG, Ti:Sapphire, Cr:Sapphire, Ce:GSO, Ce:LSO, Ce:LiCAF, Ho:LuLF, HoTm:YLT, Ce:PrF₃, LN and LT.

15. The production method of a single crystal according to one of claims 8 to 14, wherein a composition of a starting material is a composition obtained by shifting a positive ion ratio in a composition of a target single crystal by 5 to 15%.

16. A production apparatus of a single crystal which carries out pulling-down growth of the single crystal from a hole formed in a bottom portion of a crucible, wherein means for giving a temperature gradient in the vicinity of a solid-liquid interface is provided.

17. The production apparatus of a single crystal according to claim 16, wherein the means for giving a temperature gradient is constituted of a planar protruding portion having an outer diameter (S) which is not greater than fivefold of an inner diameter (B) of the crucible around the hole of the crucible on an exit side.

18. The production apparatus of a single crystal according to claim 17, wherein 1.2 < B/S < 5 is achieved.

19. The production apparatus of a single crystal according to claim 18, wherein 1.5 < B/S < 4.5 is achieved.

20. The production apparatus of a single crystal according to one of claims 17 to 19, wherein means for flowing an inert gas from a lower side toward an upper side of the crucible is provided.
